# EUROPEAN PATENT APPLICATION

(11) **EP 2 249 399 A1**
(43) Date of publication of application: **10.11.2010**
(21) Application number: 08736706.6
(22) Date of filing: 25.02.2008
(51) Int. Cl.: H01L 31/052

(54) **PHOTOVOLTAIC CONCENTRATION MODULE AND DEVICE**

(71) Applicant: Isofoton, 29590 Campanillas (Málaga) (ES)
(72) Inventor: DIAZ LUQUE, Vicente, E-29590 Campanillas (Malaga) (ES); CABRERA GODOY, Javier, E-29590 Campanillas (Malaga) (ES); EXPOSITO CORRAL, David, E-29590 Campanillas (Malaga) (ES); ALVARES RICO, José Luis, E-29590 Campanillas (Malaga) (ES)
(74) Representative: PROPI, S.L.
(86) International application number: PCT/ES2008/000104
(87) International publication number: WO 2009/106648

(57) **Abstract**

The invention relates to a photovoltaic concentration module and device. The device includes: a primary lens (10) configured to concentrate incident solar radiation and to generate a first concentrated radiation; a solar cell (30) configured to collect the first concentrated radiation; and a substrate (40) enabling the electrical connection and thermal dissipation of the solar cell, whereby the solar cell (30) and the substrate (40) are :Mectrically associated so as to form an electric power generation unit. The photovoltaic concentration module includes a series of the aforementioned devices.

## Description

### FIELD OF INVENTION

The present invention relates to the field of photovoltaic solar energy concentration systems.

### BACKGROUND OF THE INVENTION

One of the main barriers to further deployment of photovoltaic systems for power generation is the high cost. Among the various components of a photovoltaic module, the semiconductor material, a silicon wafer, is the most costly: common estimates suggest that the cost of solar grade silicon accounts for 50% of the total cost of a module. One of the ways with the greatest potential for cheaper systems is to use an optical system of concentration. Said optical system can capture the incident light on a particular area and focus it on a solar cell of a smaller size. In this way, a lot of material for a semiconductor light catchment area equivalent is saved. Moreover, solar cells can achieve greater efficiency when working under concentrated light.

According to the configuration of the optical system herein, concentration systems are classified in two basic groups:
- systems based on refraction (lenses); and,
- systems using mirrors, i.e. based on specular reflection.

In the first group, the approach most widely used is the so-called Fresnel lens; among the second group, the most common approach is to use parabolic mirrors.

So far there have been very different solutions to implement concentration photovoltaic systems.

### DESCRIPTION OF THE INVENTION

The present invention proposes an optical system that includes two aspherical surface lenses with a solar cell for obtaining a photovoltaic concentration module which meets the following characteristics:
- A high range of geometrical concentration (optical system opening area to cell active area ratio of 500);
- High light transmission efficiency (above 80%);
- Wide angular acceptance;
- Low cost manufacturing;
- High modularity.

### BRIEF DESCRIPTION OF THE DRAWINGS

Next, drawings will now be described in briefly to help better understand the invention and they are particularly related to an embodiment of said invention that constitutes a non-limiting example of the invention.
Figure 1 is a schematic drawing of a single device of the invention, consisting of a lens called primary lens that receives the solar radiation, a lens called secondary lens that receives the concentrated radiation from the primary lens, a solar cell that receives radiation emerging from the secondary lens and a substrate which simultaneously allows heat dissipation and device's electrical interconnection.
Figure 2 shows a typical embodiment of a concentration photovoltaic module assembly based on the device of the invention.

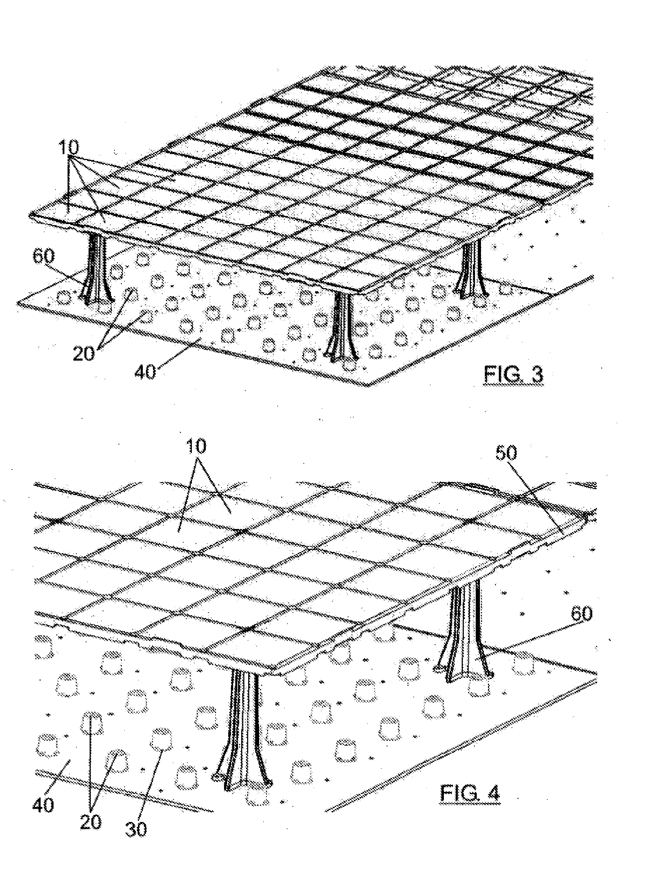

Figure 3 is a view from inside the module according to a typical embodiment according to the typical configuration of a concentration module assembly based on the association of individual systems consisting of: a primary lens, a secondary lens, a solar cell and a substrate.
Figure 4 shows a detail of the arrangement of figure 3 indicating therein: primary lens, secondary lens, solar cell, substrate for electric and thermal power interconnection, means for positioning the primary lens, part of separation to place the secondary lens at the focal length of the primary lens.

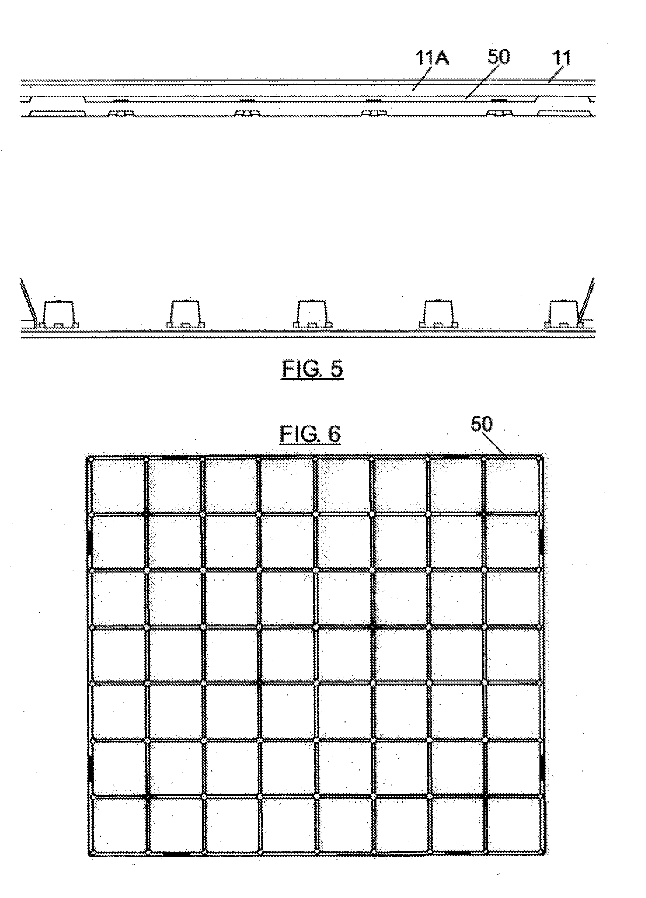

Figure 5 is a cross-section of the concentration module that shows the front protective panel made of a transparent material and means of adhesion between the primary lenses and said front protective panel.
Figure 6 shows a top view of a typical configuration for the association of primary lenses by a piece of positioning.

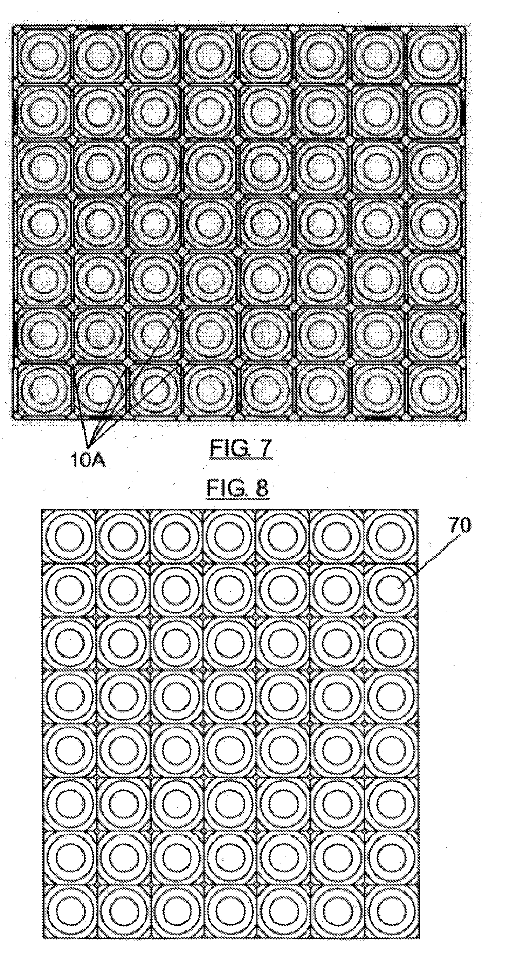

Figure 7 shows the same configuration of figure 6 using a piece of association between primary lenses with optical functionality.
Figure 8 shows a configuration of an association of primary lenses to form a single piece seamless between the primary lenses from each individual concentration device.

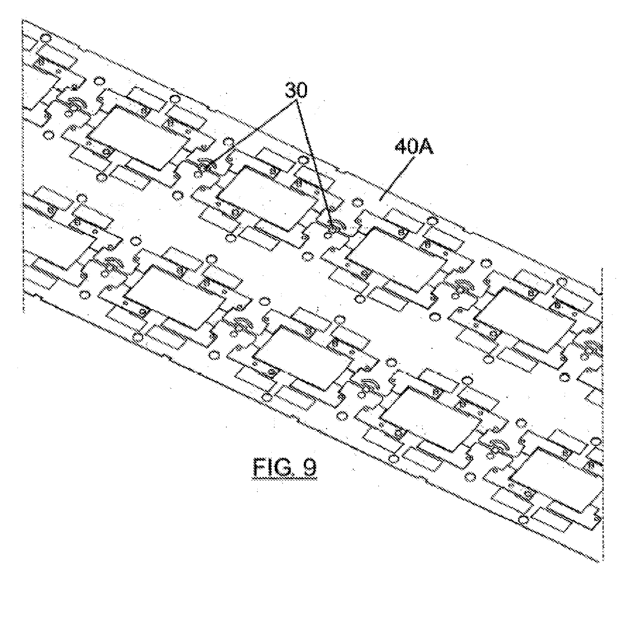

Figure 9 shows a substrate for electrical interconnection and heat dissipation aimed to associate electrically the solar cells.

### DESCRIPTION OF A PREFERRED EMBODIMENT OF THE INVENTION

The typical configuration of the concentration photovoltaic module assembly of the invention comprises the electrical and mechanical association of individual concentration devices, each device comprising: 2 lenses (10, 20), a photovoltaic solar cell (30) and a substrate (40) for electrical interconnection and heat dissipation. The associated sets of individual systems are housed in a case or box with a side frame, a transparent glass or plastic front and rear panels. In this case or box the electrical connection module is removed. Another possible configuration for the module is the association of individual concentration devices with a single lens, i.e. consisting of: a primary lens (10), a photovoltaic solar cell (30) and a substrate (40) for electrical interconnection and heat dissipation.

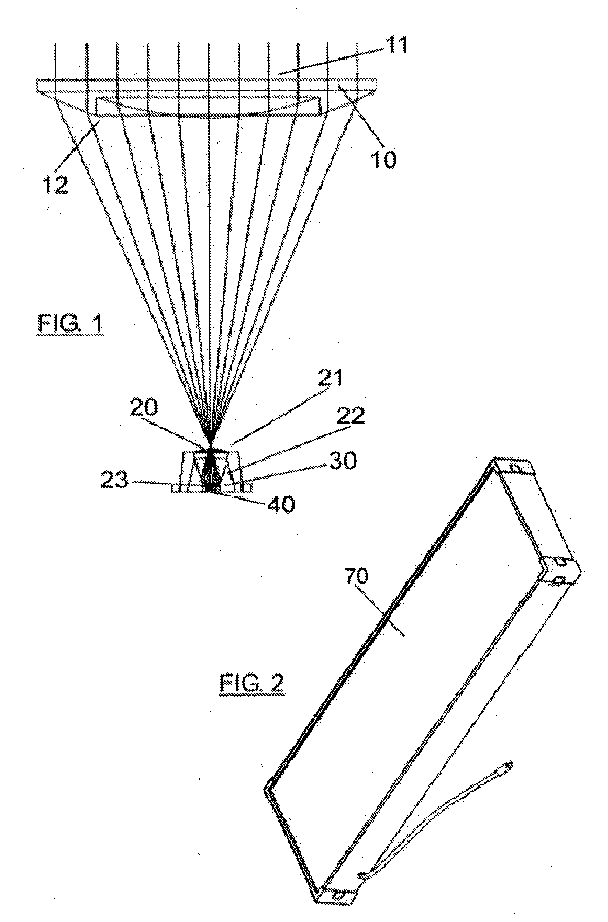

The individual concentration photovoltaic device of the invention is based on an optical system shown in Figure 1. The system includes one or two lenses, generically called primary lens (10) and secondary lens (20).

The primary lens (10) is a surface flat, spherical or aspherical lens designed in such a way that focuses light from the sun on the input surface of secondary lens (20) or onto the solar cell (30). In the most common configuration, the lens is composed of two surfaces: an input surface (11) for receiving radiation from the sun, and an output surface (12) for transmitting the concentrated radiation. Any of surfaces before may have a Fresnel lens type structure which reduces the thickness while keeping all the optical properties.

The secondary lens (20) has at least two optical surfaces: a spherical, flat or aspherical input surface (21) and a flat, spherical or aspherical output surface (23). In other configurations, the lens has a third optical surface functionality (22). This surface is usually designed so that the beam from the primary lens (10) and striking the input surface (21) of the secondary lens (20) are directed to the lateral surface (22) with an incident angle so that the beam is reflected by total internal reflection and traverse through the emitting surface (23) to strike on the solar cell (30).

Thus, an embodiment of the invention relates to a photovoltaic concentration device comprising:
a primary lens (10) configured to concentrate incident solar radiation and to generate a first concentrated radiation;
a solar cell (30) configured to collect the first concentrated radiation;
a substrate (40) for electrical connection and thermal dissipation of the solar cell;
being the solar cell (30) and substrate (40) associated electrically to form a power generation unit.

In another embodiment of the invention, the device comprises a secondary lens (20) between the primary lens (10) and the solar cell (30) configured to collect the first concentrated radiation and generate a second concentrated radiation.

On the other hand, at least one lens selected from the primary lens (10) and the secondary lens (20) has an optical surface selected from a flat, spherical and aspherical surface in the input surface (11, 21) and on the output surface (12, 23).

Additionally, the device further comprises at least one piece of vertical separation (60) for positioning the secondary lens (20) at a focal length of the primary lens (10).

According to another embodiment of the invention, the device further comprises:
a protective layer (11) in the incident face on the primary lens (10);
adherence means (11A) selected from mechanical, chemical, optical encapsulation substances and combinations thereof to adhere the protective layer (11) to the primary lens (10).

Another aspect of the invention is related to a photovoltaic concentration module assembly comprising a plurality of devices described above.

In accordance with another embodiment of the invention, the module further comprises a positioning piece (50) for grouping a plurality of primary lenses (10) and to locate each primary lens (10) on an item selected from a cell (30) and a secondary lens (20).

In a module of the invention, the positioning piece (50) has an optical functionality (10A) to concentrate the incident radiation onto the surface on an item selected from a cell (30) and a secondary lens (20).

According to another embodiment of the module, primary lenses (10) are associated with each other seamlessly to form a single mechanical part (70).

In another embodiment of the invention, a set of items selected from a plurality of solar cells (30) and a plurality of solar cells (30) and secondary lens (20) is located on a single substrate (40A) configured to perform the electrical interconnection, heat dissipation and spatial positioning functions of each one.

## Claims

1. A photovoltaic concentration device assembly **characterized in that** it comprises:
a primary lens (10) configured to concentrate incident solar radiation and
generate a first concentrated radiation;
a solar cell (30) configured to collect the first concentrated radiation;
a substrate (40) for electrical connection and thermal dissipation of the solar
cell;
being the solar cell (30) and substrate (40) associated electrically to form a power generation unit.

2. The device of claim 1 **characterized in that** it further comprises: a secondary lens (20) between the primary lens (10) and the solar cell (30), configured to collect the first concentrated radiation and generate a second concentrated radiation.

3. The device of any of claims 1-2 **characterized in that** it further comprises at least one piece of vertical separation (60) for positioning the secondary lens (20) to a focal length of the primary lens (10).

4. The device of any of claims 1-3 **characterized in that** it further comprises:
a protective layer (11) in the incidence face at the primary lens (10);
means of adherence (11A) selected from mechanical, chemical, optical encapsulation substances and combinations thereof to adhere the protective layer (11) to the primary lens (10).

5. A photovoltaic concentration module **characterized in that** it comprises a plurality of devices according to any of claims 1-4.

6. The module of claim 5 **characterized in that** it further comprises a positioning piece (50) for grouping a plurality of primary lenses (10) and to locate each primary lens (10) on an item selected from a cell (30) and a secondary lens (20).

7. The module of claim 6 **characterized in that** the positioning piece (50) has an optical functionality (10A) to concentrate the incident radiation on its surface on an element selected from a cell (30) and a secondary lens (20).

8. The module of claim 5 **characterized in that** the primary lenses (10) are associated with each other seamlessly to form a single mechanical part (70).

9. The module of any of claims 5-8 **characterized in that** a set of items selected from a: plurality of solar cells (30) and a plurality of solar cells (30) and secondary lenses (20) is located on a single substrate (40A) configured to perform of electrical interconnection, heat dissipation and spatial positioning functions of each.
